# EUROPEAN PATENT APPLICATION

(11) **EP 2 312 623 A1**
(43) Date of publication of application: **20.04.2011**
(21) Application number: 09794427.6
(22) Date of filing: 07.07.2009
(51) Int. Cl.: H01L 21/60, H05K 3/34

(54) **MICRO-BALL REMOVAL METHOD AND REMOVAL DEVICE, AND MICRO-BALL BATCH MOUNTING METHOD AND BATCH MOUNTING DEVICE**

(30) Priority: 11.07.2008 JP 2008182050
(71) Applicant: Nippon Steel Materials Co., Ltd., Tokyo 101-0021 (JP)
(72) Inventor: ISHIKAWA, Shinji, Tokyo 100-8071 (JP); HASHINO, Eiji, Tokyo 100-8071 (JP); TATSUMI, Kohei, Tokyo 101-0021 (JP)
(74) Representative: Vossius & Partner
(86) International application number: PCT/JP2009/062353
(87) International publication number: WO 2010/004983

(57) **Abstract**

A micro-ball (2) remained on a suction plate (11) is removed using a ball removal implement (9) having a wire section that is stretched under tension, by bringing a wire (17) into contact with the micro-ball (2) remained on the suction plate (11), while moving the ball removal implement (9) in relation to the suction plate (11) and moving the wire (17) in the wire section by extending and retracting the wire.

## Description

### TECHNICAL FIELD

The present invention relates to a mounting method and an apparatus of micro-balls according to a manufacturing method and a manufacturing apparatus of a semiconductor device, and particularly to a removal method and a removal device of an unnecessary micro-ball remained on a suction plate after the micro-balls are mounted on an object to be mounted.

### BACKGROUND ART

Regarding a manufacturing method of a semiconductor device, in a conventional micro-ball mounting method in which micro-balls are sucked and held to a suction plate having a plurality of suction holes and the micro-balls are mounted on specific positions on an object to be mounted, there is a technique, as a method of removing an unnecessary micro-ball (remaining ball) remained on the suction plate after mounting the micro-balls on the object to be mounted such as a wafer and a substrate, with which a nozzle is moved to a position of the detected remaining ball and is further approximated to the ball, and thereafter, gas is sucked or injected into or from the nozzle, to thereby remove the remaining ball.

However, strictly speaking, a ball holding surface on the suction plate is not a perfect horizontal surface and has a subtle inclination and slight projections and depressions. When a micro-ball to be used is quite small to have a diameter in a level of 0.25 mm or smaller, further in a level of 0.15 mm or smaller, and particularly in a level of 0.10 mm or smaller, the inclination and the projections and depressions on the ball holding surface are not allowable as a simple error. If the ball holding surface and a suction (or gas injection) nozzle to be a removal unit of the individual unnecessary micro-balls to be removed are controlled to have a certain amount of approximation, distances between the balls and the nozzle become different, which results in producing a case where a removal effect cannot be exhibited when the nozzle cannot be sufficiently approximated to the balls, and conversely, if the nozzle is approximated too much to the balls, the suction plate is damaged by the nozzle. To solve this problem, there is proposed a unit of detecting a subtle distance between the ball holding surface and the suction nozzle, as disclosed in Patent Document 1, for example.

However, when the ball has a diameter in a level of 0.20 mm or smaller, and particularly in a level of 0.15 mm, it is required to perform experiments again and again to set a sensitivity of the aforementioned unit of detecting the distance between the ball holding surface and the nozzle, which turns out to be a complicated work that takes a long time, and it is difficult to determine a subtle distance at the time of adjusting the sensitivity, which results in producing a case where an unnecessary ball cannot be removed, which were problems.
Further, when collective mounting is performed on a wafer or the like having a large area, since an area capable of being covered by a nozzle is small, there is a need to detect a position of a remaining ball, so that when micro-balls are mounted, quite a long period of time of detection such as high-precision image processing is required, which was a cause to deteriorate an efficiency of the mounting process.

Incidentally, regarding a remaining ball remained after balls are mounted on an object to be mounted, an adhesive flux previously coated on the object to be mounted is often adhered to a bottom of the remaining ball on the side opposite to that of a suction plate. When such a ball is removed, if a nozzle to be a removal unit is brought into contact with the remaining ball, there occur problems such that the flux adheres to the nozzle to contaminate the nozzle and the flux adheres to a ball holding surface of the suction plate to contaminate the ball holding surface, which was a cause to increase the number of unnecessary balls in the following ball suction process.

On the contrary, there is disclosed, in Patent Document 2, a removal method of a micro-ball **characterized in that** a plate-shaped suction ball removal implement that covers equal to or greater than a width in an orthogonal direction with respect to a moving direction of a suction area is moved in relation to a suction plate in a space sandwiched by a plane parallel to a suction surface of the suction plate and at which a cross-sectional diameter of the remaining ball becomes maximum and the suction surface, and the micro-ball removed by being brought into contact with the implement is sucked by a nozzle, to thereby remove the micro-ball remained on the suction plate.

However, in this method, since the ball is removed by bringing the plate-shaped implement into contact with the ball, it is still required to perform alignment between a ball holding surface of the suction plate and the implement to prevent the plate-shaped implement from being brought into contact with the suction plate and damaging the plate. Further, there are cases in which the remaining ball is sandwiched between the suction plate and the implement, and a flux adheres to and does not come off from the implement.

Further, Patent Document 3 discloses an adhesion removal unit as a unit of removing an unnecessary conductive ball remained on a mount head. A concrete method performed by the adhesion removal unit is a method in which a film with an adhesive is disposed between a film take-up portion and a film supply portion, and further, the film is brought into contact with the unnecessary conductive ball with the use of a film adhesion mechanism (roll) provided between the both portions so that the ball is adhered to be removed.

However, in this method, the adhesive of the film may adhere to a suction plate to cause the generation of unnecessary balls, or the unnecessary ball may be pushed into a hole of the suction plate when the film is strongly brought into contact with the ball for securely removing the unnecessary ball, which sometimes makes it further difficult to remove the ball.

### CITATION LIST

### PATENT LITERATURE

Patent Document 1: Japanese Patent Application Laid-open No. 2004-22745
Patent Document 2: Japanese Patent Application Laid-open No. 2007-311414
Patent Document 3: Japanese Patent Application Laid-open No. 2005-56901

### SUMMARY OF THE INVENTION

### TECHNICAL PROBLEM

The present invention has an object to solve the problems of the conventional technique described above and to provide micro-ball removal method and removal device, and micro-ball collective mounting method and collective mounting apparatus capable of easily and securely removing an unnecessary micro-ball, with which a difficult and complicated work of adjusting a degree of parallelization between a suction plate and a ball removal implement is eliminated, a detection of position of a remaining ball is unnecessary even when collective mounting is performed on a wafer or the like having a large area, the ball removed by a contact of the removal implement is not sandwiched between the suction plate and the removal implement, and the suction plate is not damaged even when the removal implement is brought into contact with it.

### SOLUTION TO PROBLEM

In order to solve the aforementioned problems, a first invention adopts the following unit as a removal method of a micro-ball.
It is a micro-ball removal method being a method of removing, after a suction plate having a plurality of suction holes sucks and holds micro-balls and the micro-balls are mounted on specific positions on an object to be mounted, a micro-ball remained on the suction plate, **characterized in that** the micro-ball remained on the suction plate is removed using a ball removal implement having a wire section that is stretched under tension, by bringing a wire into contact with the micro-ball remained on the suction plate, while moving the ball removal implement in relation to the suction plate and moving the wire in the wire section by extending and retracting the wire.

Secondly, it is the micro-ball removal method described in claim 1, **characterized in that** the ball removal implement has both the wire section that is stretched under tension and a slit-type nozzle that sucks and injects gas.
Thirdly, it is the micro-ball removal method described in claim 1 or 2, **characterized in that** a vibration is applied to the wire used in the ball removal implement.
Fourthly, it is the micro-ball removal method described in any one of claims 1 to 3, **characterized in that** a diameter of the wire used in the ball removal implement is equal to or less than twice a diameter of the micro-ball to be removed.

A fifth invention is a micro-ball removal device being a device for removing, using a ball removal implement, a micro-ball remained on a suction plate having a plurality of suction holes, characterized by at least including: the ball removal implement having at least a wire section that is stretched under tension and a unit of moving a wire in the wire section by extending and retracting the wire; and a unit of moving the ball removal implement in relation to the suction plate.

Sixthly, it is the micro-ball removal device described in claim 5, **characterized in that** the ball removal implement has a unit of sucking and injecting gas from and to the suction plate.
Seventhly, it is the micro-ball removal device described in claim 5 or 6, **characterized in that** the ball removal implement has a unit of applying a vibration to the wire.

Further, an eighth invention is a micro-ball collective mounting method being a micro-ball collective mounting method of collectively mounting micro-balls sucked to a plurality of suction holes formed on a suction plate on specific positions on an object to be mounted, **characterized in that** a micro-ball remained on the suction plate after performing the collective mounting is removed by using the micro-ball removal method described in any one of claims 1 to 4.

Further, a ninth invention is a micro-ball collective mounting apparatus being a micro-ball collective mounting apparatus at least having a mount head, a suction plate attached to a lower surface of the mount head, a micro-ball supply device, an object to be mounted holding device, and mount head moving devices, characterized by including the micro-ball removal device described in any one of claims 5 to 7 in the collective mounting device.

### ADVANTAGEOUS EFFECTS OF INVENTION

According to the present invention, a difficult and complicated work of adjusting a degree of parallelization between a suction plate and a ball removal implement can be eliminated at a time of removing an unnecessary micro-ball remained on the suction plate. Further, it is not necessary to detect a position of a remaining ball even when collective mounting is performed on a wafer or the like having a large area. Furthermore, the ball removed by a contact of the removal implement is not sandwiched between the suction plate and the removal implement. In addition, the suction plate is not damaged even when the removal implement is brought into contact with it. Accordingly, it is possible to provide micro-ball removal method and removal device, and micro-ball collective mounting method and collective mounting apparatus capable of easily and securely removing an unnecessary micro-ball.

### BRIEF DESCRIPTION OF DRAWINGS

Fig. 1 is a view schematically explaining an entire solder ball mounting apparatus according to an embodiment of the present invention;
Fig. 2A is a plan view showing an inspection image obtained by a detection camera in the present invention, and is a view showing an inspection image when an excess ball at a time of suction of balls is detected;
Fig. 2B is a plan view showing an inspection image obtained by the detection camera in the present invention, and is a view showing an inspection image when remaining balls after mounting the balls are detected;
Fig. 3A is a side view showing a positional relation between a mount head and a removal implement at a time of removing the excess ball in the present invention;
Fig. 3B is a front view showing a positional relation between the mount head and the removal implement at the time of removing the excess ball in the present invention;
Fig. 4A is a side view showing a positional relation between the mount head and the removal implement at a time of removing the remaining balls in the present invention;
Fig. 4B is a front view showing a positional relation between the mount head and the removal implement at the time of removing the remaining balls in the present invention;
Fig. 5A is a plan view showing a relation of moving directions of the mount head and the removal implement at the time of removing the remaining balls in the present invention;
Fig. 5B is a plan view showing a relation of moving directions of the mount head and the removal implement at the time of removing the remaining balls in the present invention;
Fig. 6 is a view showing a positional relation among the remaining ball, a wire and a slit nozzle in the present invention; and
Fig. 7 is a view showing a schematic structure of another example of the solder ball mounting apparatus according to the present invention.

### DESCRIPTION OF EMBODIMENTS

Hereinafter, embodiments of the present invention will be described together with examples, in accordance with the drawings.

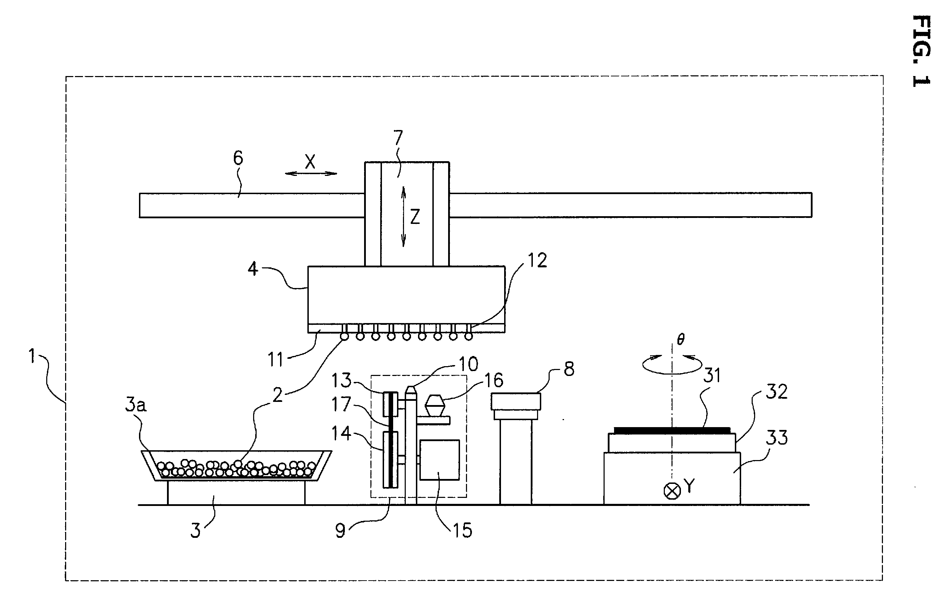

Fig. 1 is a schematic explanation diagram showing an entire solder ball mounting apparatus 1 cited as an example. In the present embodiment, a solder ball 2 with a diameter of 0.1 mm is used as a micro-ball in the present invention. Note that the micro-ball in the present invention is not limited to a conductive and low-melting point material such as the solder ball 2, and since the micro-ball is only required to have an electrical conduction, it is also possible to use gold (Au) or gold (Au) alloy, tin (Sn) or tin (Sn) alloy, silver (Ag) or silver (Ag) alloy, copper (Cu) or copper (Cu) alloy, or the like, and another high-melting point material may also be used. Further, in the present embodiment, a wafer 31 is used as an object to be mounted, but, other than the wafer 31, a printed circuit board such as a small chip and a BGA (Ball Grid Array), or a ceramics substrate may also be used.

The solder ball mounting apparatus 1 includes: a ball supply device 3 in which a large number of solder balls 2 in Fig. 1 are stored; a mount head 4 which holds the solder balls 2 by vacuum-sucking the balls; an X-axis moving device 6 for the mount head 4 (moving device in a horizontal direction in Fig. 1); a Z-axis moving device 7 for the mount head 4 (moving device in a longitudinal direction in Fig. 1); an inspection camera 8 that detects a position of an excess solder ball, a remaining solder ball, or the like; a ball removal device 9 that removes the excess solder ball or the remaining solder ball; and a Y-*θ* table 32 on which the wafer 31 is mounted and capable of moving-rotating in the Y-*θ* axis directions.

The X-axis moving device 6 for the mount head 4 and the Z-axis moving device 7 for the mount head 4 correspond to a moving mechanism that causes the relative movement of the mount head 4 between the ball supply device 3 and the Y-θ table 32. Since it is only required to cause the relative movement, it is of course possible to design such that the *Y*-θ table 32 and the like are moved, or both the table and the like and the mount head are moved.

The movement of the mount head 4 caused by the X-axis moving device 6 and the Z-axis moving device 7 includes a movement to above the ball supply device 3, upward and downward movements for the suction of balls, a movement to above a slit nozzle 10 for removing an unnecessary micro-ball such as an excess ball and a remaining ball, a movement in the X-axis direction at the time of performing removal operation of the unnecessary ball, a movement in the X-axis direction at the time of inspecting the unnecessary ball, a movement to above the Y-*θ* table 32, upward and downward movements for conducting the ball mounting operation, and the like.

The Y-*θ* table 32 is structured such that a *θ-*axis drive section is placed on a Y-axis drive table 33 so that the table can be moved in the Y-axis direction (direction orthogonal to the paper in Fig. 1) and in the *θ*-axis direction (rotational direction), and is used when performing alignment at the time of mounting.

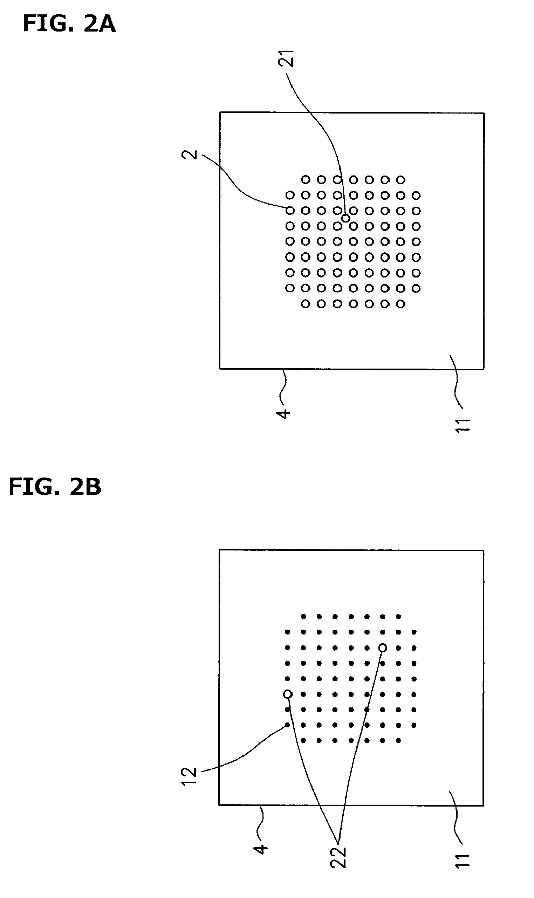

As shown in Fig. 1 and Fig. 2B, a suction plate 11 on which a plurality of suction holes 12 for sucking and holding the solder balls 2 are formed, is attached to a lower surface of the mount head 4. A ball accommodating container 3a is placed on a not-shown vibration oscillating source, and is vibrated at the time of suction of the balls to make the solder balls 2 in the container uniformly jump to be dispersed so that the respective balls are easily sucked to the respective holes of the plurality of suction holes formed on the suction plate 11, in a manner that one ball is sucked to one hole. A vibration frequency of the ball accommodating container 3a at the time of suction is 10 to 50 kHz.

The mount head 4 is connected to a not-shown vacuum suction source, and sucks and holds each of the solder balls 2 to each of the plurality of suction holes 12 formed on the suction plate 11, with the use of a negative pressure generated by the vacuum suction. Further, the mount head 4 is provided with a not-shown vibration generating source with which a vibration can be applied so that excess solder balls 2 are not sucked at the time of suction of the balls. In order not to simultaneously remove the ball which is to be normally sucked, the vibration is applied under previously set condition with which only unnecessary balls can be removed. A vibration frequency applied to the mount head 4 is 1 kHz to 1 MHz. Further, it is also possible that the vibration applied to the mount head 4 is also used at the time of mounting the balls so that the sucked solder balls 2 are easily separated from the suction plate 11 to be mounted onto the object to be mounted. A vibration frequency when the mounting is performed is 100 Hz to 1 MHz.

Further, regarding the vibration, by vibrating the mount head 4 also in a process of removing an unnecessary solder ball, it is possible to enhance an effect of removing the unnecessary solder ball. A vibration frequency in this case is 1 kHz to 1 MHz. The vibration frequency is appropriately determined based on a size of the ball to be used, the total number of balls and an arrangement state. In particular, since no suction is provided when mounting the balls, the application of frequency in a level of 100 Hz (100 Hz to 900 Hz, for instance) is also sometimes effective at the time of mounting the balls.

The inspection camera 8 is for detecting a position of an unnecessary solder ball, and correctly, the camera is for detecting a position of an excess ball 21, on the suction plate 11, unnecessarily held to the mount head 4 which sucks and holds the solder balls 2 from the ball supply device 3, as shown in Fig. 2A, or positions of remaining balls 22, on the suction plate 11, still held to the suction plate 11 without being mounted on the wafer 31 after the solder balls 2 are mounted on the wafer 31 with the use of a mounting section, as shown in Fig. 2B.

Specifically, the detection of the unnecessary excess ball 21 or remaining balls 22 with the use of the inspection camera 8 can be performed in both an approach route (moving route before mounting the balls) and a return route (moving route after mounting the balls) of the mount head 4. Fig. 2A is an inspection image detected by the inspection camera 8 in the approach route, in which the solder balls 2 properly sucked and held and the excess ball 21 being an unnecessary solder ball are detected on the suction plate 11. On the other hand, Fig. 2B is an inspection image detected by the inspection camera 8 in the return route, in which unnecessary solder balls not mounted are detected on the suction plate 11 as the remaining balls 22.

According to the present invention, since the detection by the inspection camera 8 in the return route (after the mounting) is not necessarily performed, and the remaining ball can be removed by performing a collective removal operation on the suction plate right after the mounting, it is possible to simplify the process. However, it is also possible to design such that the removal operation is omitted when the remaining ball 22 does not exist and the operation is conducted when the remaining ball 22 exists, in accordance with the result of conducting the inspection in the return route.

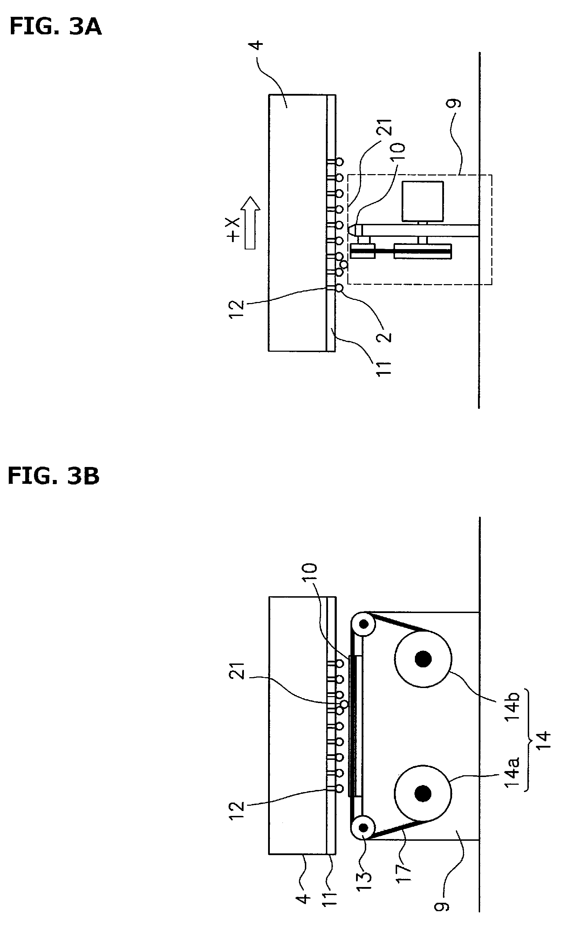

Fig. 3A and Fig. 3B relate to the ball removal device 9, and illustrate states when the removal operation of the excess ball 21 is performed. By moving the mount head 4 in the +X direction while injecting or sucking gas from or into the slit nozzle 10 connected to not-shown ventilation path and vacuum suction source, the excess solder ball is removed. Note that the slit nozzle 10 has a length capable of covering the entire removal area with respect to the X-axis direction of the mount head 4. For example, when solder balls are mounted on a wafer of 8 inches (200 mm), the length of the slit nozzle 10 is 200 mm or more (length of channel in a lateral direction (Y direction) of an upper surface of the slit nozzle 10 in Fig. 3B). Further, when a diameter of the solder ball 2 is 0.1 mm, a slit width of the slit nozzle 10 is, for example, 0.2 to 1.0 mm, and is preferably 0.3 to 0.8 mm. Specifically, the slit nozzle 10 having a slit shape of its upper surface of 210 mm X 0.6 mm is suitably employed. Note that when the excess ball is removed, a wire section used for removing the remaining ball is in a state of being lowered.

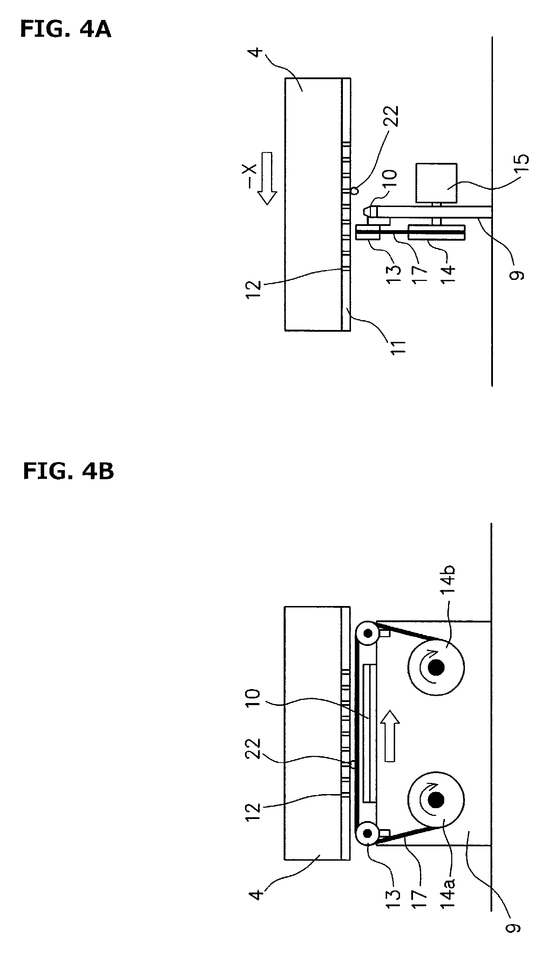

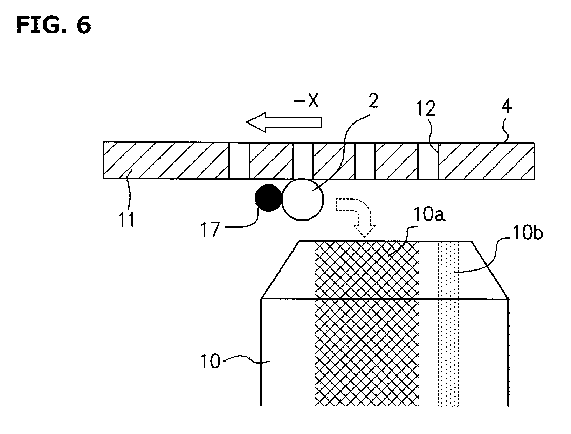

Fig. 4A and Fig. 4B illustrate states of performing the removal operation of the remaining balls 22 after mounting the balls. The mount head 4 is moved in the -X direction while making a wire 17 to be raised to a position higher than the upper surface of the slit nozzle 10 so that the mount head 4 and the wire 17 are approximated at a position at which the slit nozzle 10 does not interfere with them and the wire 17 is brought into contact with the remaining ball. Further, at the same time, the wire 17 is moved from a supply reel 14a to a take-up reel 14b of a drive reel 14 with the use of a reel drive mechanism 15 while applying tension to the wire 17, and the removed remaining ball is sucked and retrieved (sucked to be retrieved) by the slit nozzle 10 (and 10a in Fig. 6). In addition to the force only in the X direction caused by the movement of the mount head 4, the force in the Y direction caused by the friction force between the mount head and the moving wire 17 acts, so that the remaining ball is easily removed from the suction plate 11.

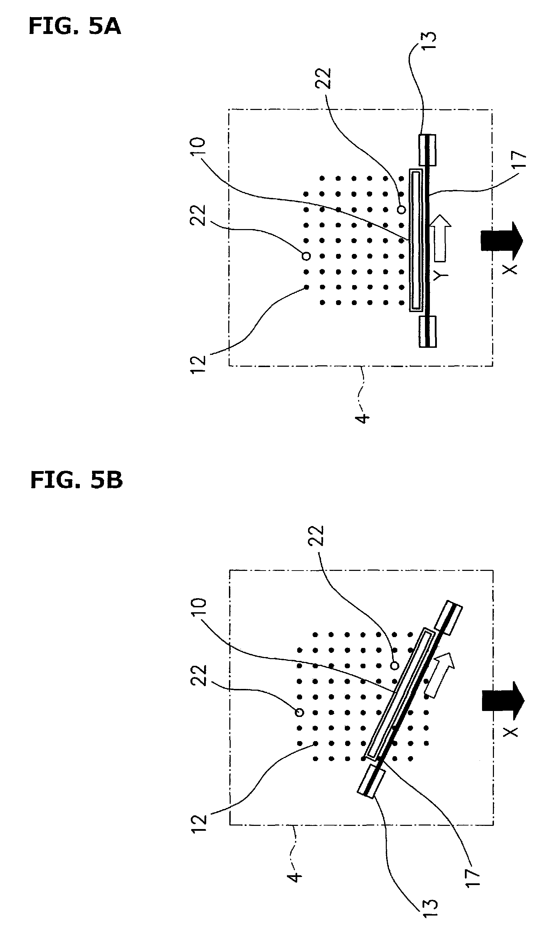

Further, when a vibration is applied to the wire 17 using an oscillator 16 (refer to Fig. 1), the removal efficiency when the wire 17 and the ball are brought into contact with each other is enhanced. Note that the moving direction of the wire 17 is not limited to the Y direction, and it may have an angle with respect to the Y direction, as shown in Fig. 5B. In this case, if the wire 17 is moved in a direction of a thick arrow mark shown in Fig. 5B, there is generated an effect of peeling off the remaining ball in the same direction as the moving direction of the mount head 4 (X direction), so that the solder ball 2 is not sandwiched between the wire 17 and the suction plate 11. Further, on the contrary, if the wire 17 is moved in a direction opposite to the moving direction of the mount head 4, an effect of peeling off the solder ball 2 in a direction opposite to the direction of the thick arrow mark in Fig. 5B is increased.

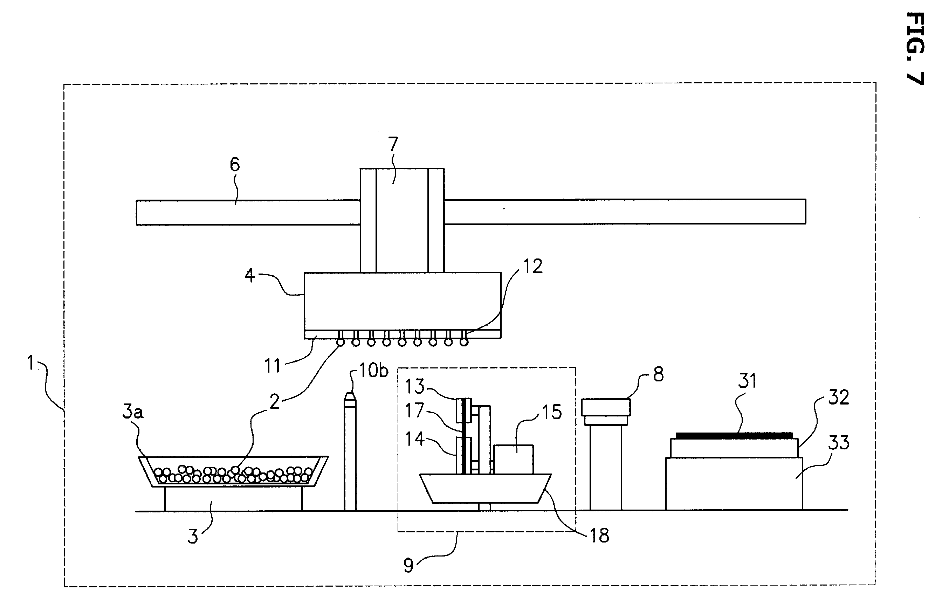

Note that although the moving speed of the wire 17 is only required to be one with which the wire 17 stretched on the upper portion of the ball removal device is taken up until the new part thereof is set during the remaining ball removal which is normally performed one time, when the wire is taken up rapidly, the aforementioned effect of peeling off the ball is increased. Further, by taking up the wire 17, the new wire 17 is always used for removing the remaining ball, so that even if the flux from the remaining ball or dirt generated by another factor adheres to the wire section, no influence is imposed on the following processing. When the wire 17 becomes dirty as described above, it may be cleaned to be used again. Although not shown in Fig. 1 and Fig. 7, it is also possible to additionally provide a wire cleaning device that cleans the dirt on the wire 17. By additionally providing the wire cleaning device, it is possible to reduce the number of exchanging the wire 17. Further, by providing the endless wire 17 and combining the wire with the wire cleaning device, it is possible to further reduce the number of exchanging the wire 17.

Any method can be employed to apply the tension to the wire 17, in which a method of differentiating a control rotational speed of the supply reel 14a from that of the take-up reel 14b (increasing the speed on the side of the take-up reel 14b), a method of pulling between two raising and lowering reels 13 using springs or rubbers, a method of providing a tension control reel between the supply reel 14a or the take-up reel 14b and the raising and lowering reel, the tension control reel being pushed against the wire 17 to control the tension, and the like can be cited, for example. Further, the tension applied to the wire 17 is equal to or greater than a tension with which the wire 17 between the raising and lowering reels 13 is not loosened. The tension is, for example, 490 mN to 1960 mN.

Regarding a suitable diameter of the wire 17 used for the removal, it was proved, as a result of a large number of experiments, that the removal effect is large when the diameter of the wire is equal to or less than twice the diameter of the solder ball 2, and more preferably, when the diameter of the wire is equal to or less than a radius of the solder ball 2, a significant removal effect is provided. The diameter of the wire 17 is preferably small as described above, but, the wire has to have a diameter equal to or more than a diameter that provides strength with which the wire is not cut by tension. Concretely, the diameter of 1 *µ*m or more is preferable. The diameter of 5 *µ*m or more is preferable since a long-term durability of the wire 17 can be secured. Further, when the wire 17 whose cross section has a circular shape or an elliptical shape is used, even if the wire 17 is brought into contact with the suction plate 11, no damage is caused to the suction plate 11. As a material of the wire 17 used for the removal, resin-based fibers such as nylon, polyester and polyethylene which are soft and having high tensile strength, are more suitably employed than a metal wire. The wire 17 may also be a wire formed by directly molding a resin in a linear shape, or a wire formed by twisting fine fibers of resin. Further, it is also possible to use a coated wire being a metal wire on which a resin is coated.

A suitable moving speed of the wire 17 and a suitable angle between the moving direction of the wire 17 and the mount head 4 are selected based on the diameter of the solder ball 2 to be used, the diameter of the wire 17, an interval between the sucked solder balls 2, and the material of the wire 17.

Next, description will be made on a series of processes of a collective mounting method of micro-balls in which the micro-balls sucked to the suction plate 11 having a plurality of suction holes are collectively mounted on specific positions on an object to be mounted.
First, the mount head 4 is moved to right above the ball supply device 3, and is approximated to the ball accommodating container 3a by the Z-axis moving device 7. The ball accommodating container 3a is vibrated to make the solder balls 2 in the container jump, and the pressure in the mount head 4 is reduced by vacuum suction, thereby sucking the solder balls 2 to the suction plate 11 attached to the mount head. At this time, a vibration is applied to the mount head 4 to prevent the generation of excess balls.

The mount head 4 to which the solder balls 2 are sucked is raised to a position suitable for removing the excess ball as shown in Fig. 3A and Fig. 3B, and is moved in the right direction in Fig. 1 by the X-axis moving device 6, and when the mount head passes over the ball removal device 9, the excess ball is removed by gas injected' from a slit nozzle for injection (10b in Fig. 6) and the removed excess ball is retrieved by a nozzle for suction (10a in Fig. 6). A distance between the suction plate 11 and the slit nozzle 10 is suitably 0.15 mm to 0.3 mm when the ball diameter is 0.1 mm, for example. At this time, it is also possible to apply a vibration to the mount head 4 to increase the removal effect of the excess ball.

When the mount head 4 reaches above the inspection camera 8, the state of suction and arrangement of the solder balls 2 is photographed by the inspection camera 8, and by performing image processing based on the photograph data, the excess ball 21 unnecessarily held to the mount head 4 and a position at which the ball is not sucked are recognized and detected. If a large number of excess balls exist, the removal operation may also be performed again, and if there are a lot of portions on which the balls are not sucked, the suction operation may also be performed again.

When the number of excess balls reaches the number equal to or less than an allowable number, the process proceeds to ball mounting. Specifically, the mount head 4 is further moved in the right direction in Fig. 1, and is moved to above a position of mounting balls on the Y-*θ* table 32. Next, with the use of the Z-axis moving device 7, the mount head 4 is lowered and moved to above the wafer 31, and after the balls are abutted against the wafer, the suction is released, to thereby conduct the ball mounting operation.

After the ball mounting operation, the mount head 4 takes its return route to return to the ball supply device 3, and on the return route, when the mount head reaches above the inspection camera 8, the state of the suction plate is recognized by the inspection camera 8, and a position, on the suction plate 11, of the solder ball 2 remained on the suction plate is detected. When no remaining ball 22 exists, the process directly proceeds to the ball suction operation being the following process. When the remaining ball 22 exists, the wire section in the solder ball removal implement is set to be in a state of projecting higher than an uppermost surface of the slit nozzle 10, as shown in Fig. 4A and Fig. 4B. Further, a position of the mount head 4 is raised or lowered so that the remaining ball on the suction plate 11 is brought into contact with the wire section. Regarding a positional relation between a lower surface of the suction plate 11 and the wire 17, if there is a distance in which the wire 17 is brought into contact with the ball, a sufficient effect can be provided, but, if the ball diameter is 0.1 mm, it is suitably set such that an uppermost point of the wire becomes higher than a lowermost point of the remaining ball by about 0.07 mm (70% of the ball diameter), by considering a displacement in a degree of parallelization between the mount head 4 and the wire 17.

Thereafter, the slit nozzle for suction (10a in Fig. 6) is set to be in a state of suction, the wire 17 is moved by the take-up operation of the wire 17, and the mount head 4 is moved in the -X direction as shown in Fig. 4A, thereby removing the remaining ball 22 on the suction plate 11 and retrieving the removed ball by the slit nozzle for suction 10a. At this time, it is also possible to apply a vibration to the wire 17 or the mount head 4.

Further, a solder ball mounting apparatus shown in Fig. 7 is another example of the present invention. In the apparatus in Fig. 7, the removal of remaining ball in a remaining ball removal device is performed by using the wire 17, in the same manner as described above. In this case, the removed ball is retrieved by a removed ball retrieving container 18. Further, the removal of excess ball is independently performed, without using the remaining ball removal device.

Thereafter, the mount head 4 returns to the ball supply device 3, and a series of operations of the solder ball mounting apparatus 1 are completed. In the embodiment, the detection of the excess ball 21 and the remaining ball 22 conducted by the inspection camera 8 and the ball removal are designed to be performed one time in each of the approach route and the return route during the series of operations, but, it is also possible to determine the number of inspections and the number of removal operations depending on each purpose.

Further, in the present embodiment, the approximation between the lower surface of the mount head 4 and the slit nozzle 10 from a predetermined position to a position at which they have a predetermined distance necessary for the removal of the excess ball 21 and the remaining ball 22, is explained by lowering the mount head 4, but, it is needless to say that the approximation may also be performed by raising the slit nozzle 10 or by raising and lowering both of them.

In the processing of mounting solder balls of 0.1 mm, 100 times of the series of operations of the ball suction and the ball mounting were conducted by using the removal method and the removal device of the remaining ball according to the present invention in which nylon wires having diameters of 0.05 mm, 0.1 mm, 0.2 mm and 0.3 mm, respectively, were used. As a result, the numbers of failures of removal of the remaining ball 22 were 0, 0, 0 and 2, respectively, and 100% of removal was realized except in the case of using the wire of 0.3 mm. Further, the suction plate 11 was not contaminated by the flux adhered to the remaining ball 22, and no increase in the excess ball 21 was observed in the ball suction process being the following process.

### INDUSTRIAL APPLICABILITY

It is possible to provide micro-ball removal method and removal device, and micro-ball collective mounting method and collective mounting apparatus capable of easily and securely removing an unnecessary micro-ball when manufacturing a semiconductor device.

### REFERENCE SIGNS LIST

- 1: SOLDER BALL MOUNTING APPARATUS
- 2: SOLDER BALL
- 3: BALL SUPPLY DEVICE
- 3a: BALL ACCOMMODATING CONTAINER
- 4: MOUNT HEAD
- 6: X-AXIS MOVING DEVICE
- 7: Z-AXIS MOVING DEVICE
- 8: INSPECTION CAMERA
- 9: BALL REMOVAL DEVICE
- 10: SLIT NOZZLE
- 10a: SUCTION PORTION OF SLIT NOZZLE
- 10b: GAS INJECTION PORTION OF SLIT NOZZLE
- 11: SUCTION PLATE
- 12: SUCTION HOLE
- 13: RAISING AND LOWERING REEL
- 14: DRIVE REEL
- 14a: SUPPLY REEL
- 14b: TAKE-UP REEL
- 15: REEL DRIVE MECHANISM
- 16: OSCILLATOR
- 17: WIRE
- 18: REMOVED BALL RETRIEVING CONTAINER
- 21: EXCESS BALL
- 22: REMAINING BALL
- 31: WAFER
- 32: Y-*θ* TABLE
- 33: Y-AXIS DRIVE TABLE

## Claims

1. A micro-ball removal method being a method of removing, after a suction plate having a plurality of suction holes sucks and holds micro-balls and the micro-balls are mounted on specific positions on an object to be mounted, a micro-ball remained on the suction plate, the method comprising
removing the micro-ball remained on the suction plate using a ball removal implement having a wire section that is stretched under tension, by bringing a wire into contact with the micro-ball remained on the suction plate, while moving the ball removal implement in relation to the suction plate and moving the wire in the wire section by extending and retracting the wire.

2. The micro-ball removal method according to claim 1, wherein
the ball removal implement has both the wire section that is stretched under tension and a slit-type nozzle that sucks and injects gas.

3. The micro-ball removal method according to claim 1, wherein
a vibration is applied to the wire used in the ball removal implement.

4. The micro-ball removal method according to claim 1, wherein
a diameter of the wire used in the ball removal implement is equal to or less than twice a diameter of the micro-ball to be removed.

5. A micro-ball removal device being a device for removing, using a ball removal implement, a micro-ball remained on a suction plate having a plurality of suction holes, the device at least comprising:
said ball removal implement having at least a wire section that is stretched under tension and a unit of moving a wire in the wire section by extending and retracting the wire; and
a unit of moving said ball removal implement in relation to the suction plate.

6. The micro-ball removal device according to claim 5, wherein
said ball removal implement has a unit of sucking and injecting gas from and to the suction plate.

7. The micro-ball removal device according to claim 5, wherein
said ball removal implement has a unit of applying a vibration to the wire.

8. A micro-ball collective mounting method being a micro-ball collective mounting method of collectively mounting micro-balls sucked to a plurality of suction holes formed on a suction plate on specific positions on an object to be mounted, the method comprising
removing a micro-ball remained on the suction plate after performing the collective mounting by using said micro-ball removal method according to claim 1.

9. A micro-ball collective mounting apparatus being a micro-ball collective mounting apparatus at least having a mount head, a suction plate attached to a lower surface of the mount head, a micro-ball supply device, an object to be mounted holding device, and mount head moving devices, the apparatus comprising
said micro-ball removal device according to claim 5 in said collective mounting apparatus.
